# EUROPEAN PATENT SPECIFICATION

(11) **EP 3 190 628 B1**
(45) Date of publication and mention of the grant of the patent: **15.01.2020**
(21) Application number: 15838584.9
(22) Date of filing: 12.06.2015
(51) Int. Cl.: H01L 31/0256, H01L 31/0216, H01L 31/068, H01L 31/18

(54) **SOLAR CELL AND MANUFACTURING METHOD OF SOLAR CELL**
SOLARZELLE UND VERFAHREN ZUR HERSTELLUNG EINER SOLARZELLE
CELLULE SOLAIRE ET SON PROCÉDÉ DE FABRICATION

(30) Priority: 04.09.2014 JP 2014180220
(43) Date of publication of application: 12.07.2017
(73) Proprietor: Shin-Etsu Chemical Co., Ltd., Tokyo 100-0004 (JP)
(72) Inventor: WATABE, Takenori, Annaka-shi Gunma 379-0195 (JP); OTSUKA, Hiroyuki, Annaka-shi Gunma 379-0195 (JP)
(74) Representative: Wibbelmann, Jobst
(86) International application number: PCT/JP2015/002959
(87) International publication number: WO 2016/035229

(56) References cited:
- WO-A1-02/31892
- WO-A1-02/31892
- JP-A- 2002 076 399
- JP-A- 2002 083 981
- JP-A- 2002 083 981
- JP-A- 2003 282 901
- JP-A- 2003 282 901

## Description

### TECHNICAL FIELD

The present invention relates to a solar cell and a method for manufacturing a solar cell.

### BACKGROUND ART

Solar cells using silicon substrates doped with boron (B) have a problem of lowering the conversion efficiency due to photo-irradiation. On the other hand, it has been known that solar cells using silicon substrates doped with gallium (Ga) do not occur photo-degradation (e.g., see Patent Document 1).

On the other hand, as a surface passivation method of a silicon substrate, silicon thermal oxide films have long been known to possess excellent properties.

### CITATION LIST

### PATENT LITERATURE

Patent Document 1: Japanese Patent No. 3679366

### SUMMARY OF INVENTION

### PROBLEM TO BE SOLVED BY THE INVENTION

The gallium-doped silicon substrate (hereinafter, also referred to as a "gallium-doped substrate"), however, has a property to largely lower the dopant concentration in the substrate surface by thermal oxidation since the diffusion coefficient and the solubility of gallium in silicon are different from those in silicon oxide. Accordingly, a solar cell using a gallium-doped substrate lowers the conversion efficiency due to lowering of the dopant concentration on the substrate surface. Therefore, it has been difficult to apply a thermal oxidation to a gallium-doped substrate.

In view of the above-described problems, it is an object of the present invention to provide a solar cell that can possess high conversion efficiency while suppressing the photo-degradation even though having a silicon thermal oxide film as a passivation film of the substrate surface, and to provide a method for manufacturing such a solar cell.

### MEANS FOR SOLVING PROBLEM

The subject matter of the present invention is defined in claims 1 and 3. To achieve the above-described object, the present invention provides a solar cell comprising a gallium-doped silicon substrate having a p-n junction formed therein,
wherein the silicon substrate is provided with a silicon thermal oxide film at least on a first main surface of main surfaces of the silicon substrate, the first main surface being a main surface having a p-type region, and
the silicon substrate is further doped with boron.

The solar cell having such a structure can suppress photo-degradation since the silicon substrate is doped with gallium. In this solar cell, the silicon substrate is further doped with boron, and accordingly it is possible to prevent large lowering of the dopant concentration on the substrate surface even though the silicon substrate is provided with a silicon thermal oxide film at least on the first main surface of main surfaces of the silicon substrate, the first main surface being a main surface having a p-type region, and to prevent lowering of the initial conversion efficiency. Moreover, the solar cell has a constitution in which the silicon substrate surface is provided with the silicon thermal oxide film, which possesses an excellent property as a passivation film of a substrate surface, thus the solar cell can be a high quality solar cell with high reliability while improving the conversion efficiency thereby.

In this case, it is preferable that in the silicon substrate, at least the first main surface be a p-type entirely.

The present invention can be suitably applied to a solar cell in which the first main surface of the silicon substrate, having a silicon thermal oxide film provided thereto, is a p-type over the entire surface thereof.

The silicon substrate have a boron concentration of 5×10¹⁴ atoms/cm³ or more and 1×10¹⁶ atoms/cm³ or less.

When the boron concentration in the silicon substrate is within the range described above, it is possible to improve the initial property of the solar cell more effectively and to maintain the conversion efficiency high after photo-irradiation.

The present invention also provides a method for manufacturing a solar cell, comprising the steps of:
preparing a silicon substrate doped with gallium and boron;
forming a p-n junction in the silicon substrate; and
forming a silicon thermal oxide film at least on a first main surface of main surfaces of the silicon substrate, the first main surface being a main surface having a p-type region.

By using a gallium-doped silicon substrate as described above, photo-degradation of the manufactured solar cell can be suppressed. Moreover, since the silicon substrate to be used is further doped with boron, it is possible to prevent large lowering of the dopant concentration in the substrate surface even though a silicon thermal oxide film is formed at least on the first main surface of main surfaces of the silicon substrate, the first main surface being a main surface having a p-type region, and to prevent lowering of the initial conversion efficiency of the solar cell. Furthermore, by forming the silicon thermal oxide film, which possesses an excellent property as a passivation film of a substrate surface, on the surface of the silicon substrate, it is possible to produce a high quality solar cell with high reliability while improving the conversion efficiency.

In this case, it is preferable that the silicon substrate to be prepared have a boron concentration of 5×10¹⁴ atoms/cm³ or more and 1×10¹⁶ atoms/cm³ or less.

By using a silicon substrate having a boron concentration within such a range, it is possible to improve the initial property of the manufactured solar cell more effectively and to maintain the conversion efficiency high after photo-irradiation.

### EFFECT OF INVENTION

As described above, the solar cell of the present invention can possess high conversion efficiency while suppressing the photo-degradation even though having a silicon thermal oxide film as a passivation film of the substrate surface. Moreover, the method for manufacturing a solar cell of the present invention can produce such a solar cell.

### BRIEF DESCRIPTION OF DRAWINGS

FIG. 1 is a sectional view showing an example of an embodiment of the solar cell of the present invention;
FIG. 2 is a sectional process drawing showing an example of an embodiment of the method for manufacturing a solar cell of the present invention;.
FIG. 3 is a sectional process drawing showing an example of an embodiment of the method for manufacturing a solar cell of the present invention;
FIG. 4 is a sectional view showing another example of an embodiment of the solar cell of the present invention; and
FIG. 5 is a graph showing a relationship between a boron concentration in a silicon substrate and the initial conversion efficiency, the conversion efficiency after degradation, and the degradation degree of a solar cell using the silicon substrate.

### DESCRIPTION OF EMBODIMENTS

Hereinafter, the present invention will be specifically described with reference to FIGS. as an example of the embodiments, but the present invention is not limited thereto.

As described above, the solar cell using a silicon substrate doped with boron has a problem of lowering the conversion efficiency due to photo-irradiation. On the contrary, it has been known that the solar cell using a silicon substrate doped with gallium does not occur photo-degradation. On the other hand, as a surface passivation method of a silicon substrate, the silicon thermal oxide film has long been known to possess excellent properties. The gallium-doped substrate, however, has a property to largely lower the dopant concentration in the substrate surface by thermal oxidation, and the lowering of the dopant concentration on the substrate surface lowers the conversion efficiency. Accordingly, it has been considered that the thermal oxidation is difficult to be applied to the gallium-doped substrate.

Accordingly, the present inventors have diligently investigated on a solar cell that can possess high conversion efficiency while suppressing the photo-degradation even though having a silicon thermal oxide film as a passivation film of the substrate surface. As a result, the present inventors have found that the solar cell can possess high conversion efficiency while suppressing the photo-degradation even though having a silicon thermal oxide film as a passivation film of the substrate surface by adopting a silicon substrate doped with boron in addition to gallium-doping as a substrate for a photoelectric conversion layer of the solar cell and by providing a silicon thermal oxide film on the substrate surface, thereby bringing the present invention to completion.

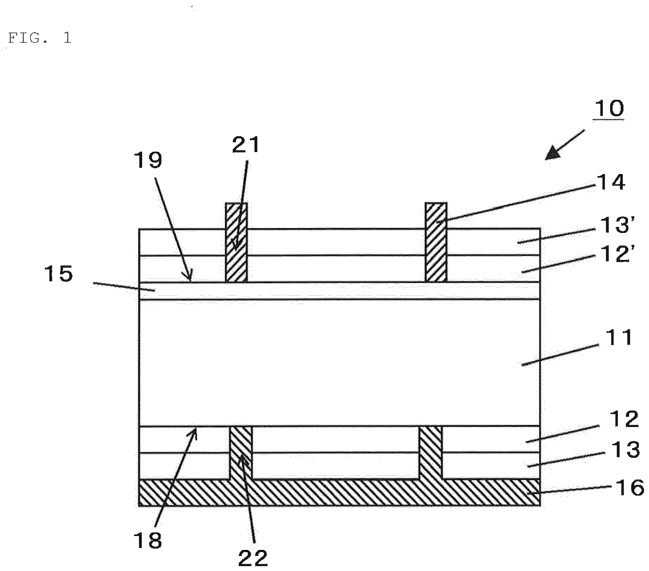

Hereinafter, an example of an embodiment of the solar cell of the present invention will be described with reference to FIG. 1.

The solar cell 10 of FIG. 1 has the silicon substrate 11 (e.g., a p-type silicon substrate) doped with gallium and boron, the emitter layer 15 provided on the front surface of the silicon substrate 11 (the second main surface 19), and the silicon thermal oxide film 12 provided on the back surface of the silicon substrate 11 (the first main surface 18), and has a structure in which the silicon substrate 11 of a p-type and the emitter layer 15 formed on the front surface of the silicon substrate 11 form a p-n junction. The emitter layer 15 is an n-type diffusion layer, for example. It is to be noted that the both sides of the silicon substrate 11 (the first main surface 18 and the second main surface 19) may be provided with the silicon thermal oxide films 12 and 12'. On the silicon thermal oxide films 12 and 12', the silicon nitride films 13 and 13' may be provided for the purpose of anti-reflection. Herein, "the first main surface" refers to the main surface having a p-type region of the silicon substrate, and "the second main surface" is the main surface opposite to "the first main surface". The p-type region can exist on both of the main surfaces. In this case, either of the surfaces is defined as "the first main surface", and the opposite main surface is defined as "the second main surface". In any event, the present invention contains a silicon thermal oxide film on the main surface having a p-type region.

The solar cell 10 of FIG. 1 can have the front surface electrodes 14, which are electrically connected to the emitter layer 15 via the openings 21, on the front surface (the second main surface 19) side of the silicon substrate 11, and can have the back surface electrode 16, which is electrically connected to the silicon substrate 11 via the openings 22, on the back surface (the first main surface 18) side of the silicon substrate 11.

In the solar cell 10, since the silicon substrate 11 is doped with gallium, photo-degradation can be suppressed. Moreover, since the silicon substrate 11 is further doped with boron, it is possible to prevent large lowering of the dopant concentration on the substrate surface even though the silicon substrate 11 is provided with a silicon thermal oxide film 12 at least on the first main surface 18 of main surfaces of the silicon substrate 11, the first main surface being a main surface having a p-type region, and to prevent lowering of the initial conversion efficiency. Furthermore, the constitution in which the front surface of the silicon substrate 11 is provided with the silicon thermal oxide film 12, which possesses an excellent property as a passivation film of a substrate surface, can make the solar cell have high reliability and be high quality.

It is preferable that at least the first main surface 18 of the silicon substrate 11 of the solar cell 10 is a p-type over the entire surface thereof.

The present invention can be suitably applied to a solar cell in which the first main surface 18 of the silicon substrate 11, having a silicon thermal oxide film 12 provided thereto, is a p-type over the entire surface thereof.

The boron concentration in the silicon substrate 11 be 5×10¹⁴ atoms/cm³ or more and 1×10¹⁶ atoms/cm³ or less.

When the boron concentration in the silicon substrate is within the range described above, it is possible to improve the initial property of the solar cell more effectively and to maintain the conversion efficiency high after photo-irradiation. Particularly, when the boron concentration exceeds 5×10¹⁴ atoms/cm³, lowering of the conversion efficiency due to photo-irradiation (photo-degradation) begins to occur by the existing boron dopant. The gallium-doped substrate, however, can be granted a passivation effect by the silicon thermal oxide film, thereby showing an effect of improving the initial efficiency larger than that of the photo-degradation at the boron concentration within a range of 5×10¹⁴ atoms/cm³ or more and 1×10¹⁶ atoms/cm³ or less. Accordingly, the conversion efficiency after photo-degradation is higher compared to the case with smaller amount of boron doping (i.e., the case without photo-degradation due to boron doping).

The solar cell of the present invention described above can possess high conversion efficiency while suppressing the photo-degradation even though having a silicon thermal oxide film as a passivation film of the substrate surface.

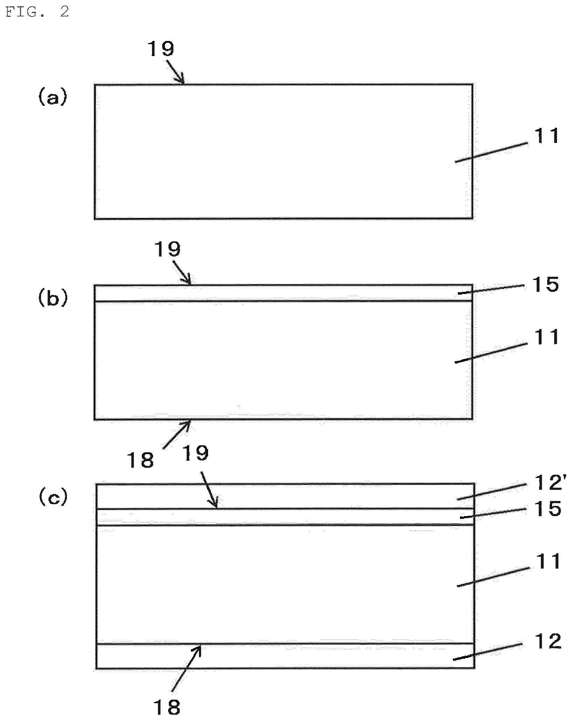

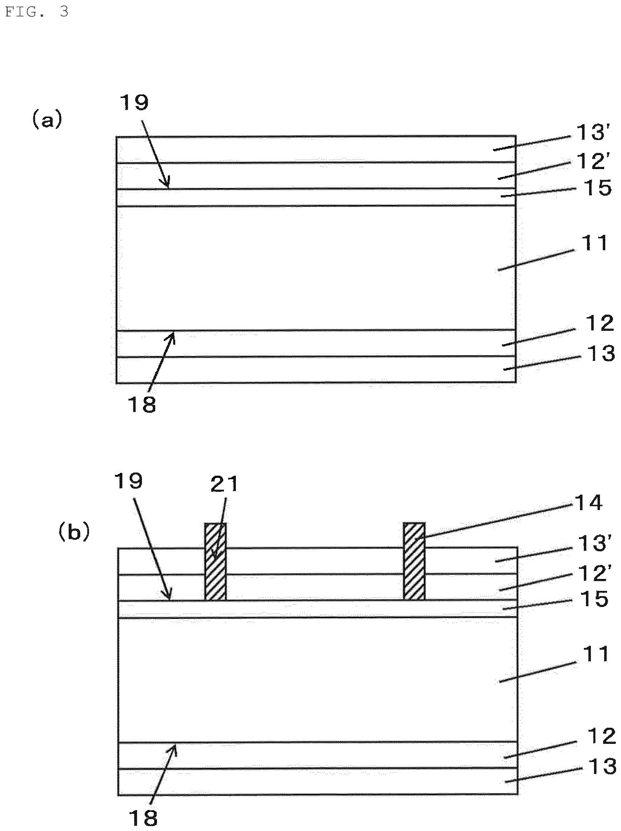

Hereinafter, an example of an embodiment of the method for manufacturing a solar cell of the present invention will be described with reference to FIG. 2 and FIG. 3.

First, a silicon substrate doped with gallium and boron (e.g., a p-type silicon substrate) 11 is prepared (see FIG. 2(a)). The silicon substrate doped with gallium and boron can be obtained by growing a silicon single crystal ingot with being doped with gallium and boron by a CZ method or an FZ method, and being subjected to slicing and a prescribed processing thereafter, for example. The silicon substrate 11 is preferably subjected to a texture processing to form fine unevenness called texture at least on the light receiving surface side when forming a solar cell (i.e., on the second main surface 19 side in FIG. 1) in order to decrease the reflectance.

Then, on the second main surface 19 side of the silicon substrate 11, the emitter layer 15 is formed to form a p-n junction (see FIG. 2(b)). The emitter layer 15 can be formed by forming an n-type diffusion layer by phosphorous diffusion, for example. In this case, the surface onto which the emitter layer 15 is formed is a main surface opposite to the first main surface 18.

Subsequently, the silicon substrate 11 is subjected to thermal oxidation in an oxygen gas atmosphere to form the silicon thermal oxide film 12 at least on the first main surface 18 of the silicon substrate 11 (see FIG. 2(c)). It is to be noted that the silicon thermal oxide films 12 and 12' may be formed on both sides of the silicon substrate 11 (i.e., the first main surface 18 and the second main surface 19). The gallium-doped silicon substrate has a property to largely lower the gallium concentration on the substrate surface by thermal oxidation since the diffusion coefficient and the solubility of gallium in silicon are different from those in silicon oxide. Accordingly, the thermal oxidation described above makes the gallium concentrations around the first main surface 18 and around the second main surface 19 of the silicon substrate 11 smaller than the gallium concentration in the interior of the silicon substrate 11. The silicon substrate 11, however, is also doped with boron, which is p-type dopant. Accordingly, the total concentration of p-type dopant around the first main surface 18 and around the second main surface 19 of the silicon substrate 11 can be larger than that in the case of being doped with gallium only.

After forming the silicon thermal oxide film(s), the silicon nitride films 13 and 13' may be individually formed on the silicon thermal oxide film 12 formed on the first main surface 18 and the silicon thermal oxide film 12' formed on the second main surface 19 of the silicon substrate 11 for the purpose of anti-reflection (see FIG. 3(a)).

After forming the silicon nitride film(s), on the second main surface 19 of the silicon substrate 11, metal film can be formed for forming the front surface electrodes 14 (see FIG. 3(b)). The front surface electrodes 14 are preferably formed of silver. The front surface electrodes 14 can be formed by a known method such as screen printing of Ag-containing paste followed by drying and baking. In this case, the front surface electrodes 14 and the emitter layer 15 can be electrically connected with each other by printing silver paste onto the film surface without opening the silicon thermal oxide film 12' and the silicon nitride film 13', followed by piercing these films at the baking.

After forming the front surface electrodes, the silicon thermal oxide film 12 and the silicon nitride film 13 formed on the first main surface 18 of the silicon substrate 11 can be partly removed, followed by forming a metal film for forming the back surface electrode 16 on the first main surface 18 of the silicon substrate 11. The back surface electrode 16 is preferably formed of aluminum. The back surface electrode 16 can be formed by a known method such as vapor deposition of Al onto the entire surface. In this way, the back surface electrode 16 can be formed to obtain the solar cell 10 of FIG. 1.

As described above, by using the gallium-doped silicon substrate, photo-degradation can be suppressed. Moreover, since the silicon substrate is further doped with boron, it is possible to prevent large lowering of the dopant concentration on the substrate surface even though the silicon thermal oxide film is formed at least on the first main surface of main surfaces of the silicon substrate, the first main surface being a main surface having a p-type region, and to prevent lowering of the initial conversion efficiency. Furthermore, by forming the silicon thermal oxide film, which possesses an excellent property as a passivation film of a substrate surface, onto the surface of the silicon substrate, it is possible to manufacture a high quality solar cell with high reliability.

It is preferable that the boron concentration of the silicon substrate to be used be set to 5×10¹⁴ atoms/cm³ or more and 1×10¹⁶ atoms/cm³ or less.

By using a silicon substrate having a boron concentration within such a range, the initial property of the manufactured solar cell can be improved more effectively, the photo-degradation can be decreased, and the conversion efficiency after photo-irradiation can be maintained high.

By the method for manufacturing a solar cell of the present invention described above, it is possible to produce a solar cell that can possess high conversion efficiency while suppressing the photo-degradation even though the silicon thermal oxide film is formed as a passivation film of the substrate surface.

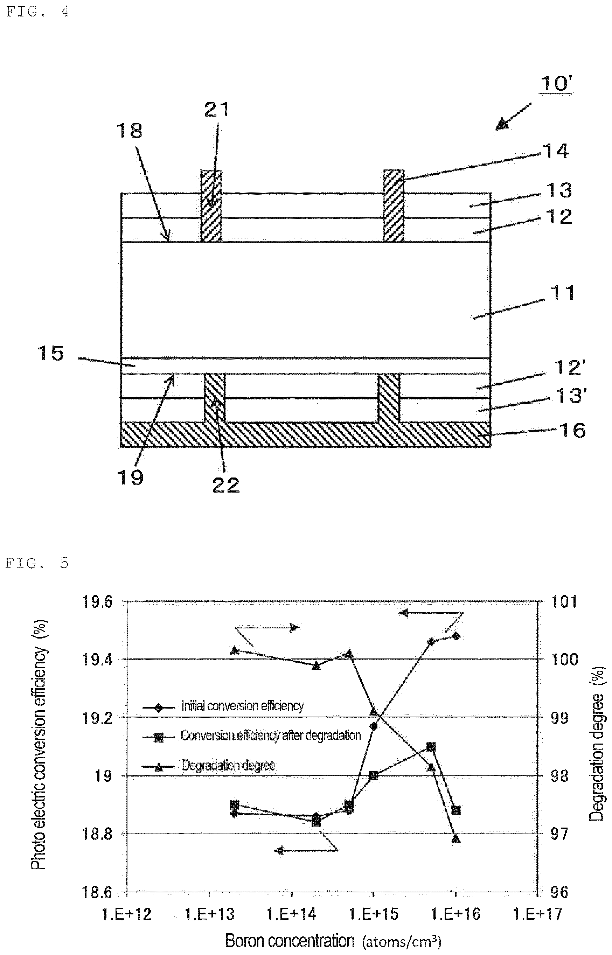

Hereinafter, another example of an embodiment of the solar cell of the present invention will be described with reference to FIG. 4.

The solar cell 10' of FIG. 4 is the same as the solar cell 10 of FIG. 1, except that the emitter layer 15 is provided on the back surface (the second main surface 19) side. The solar cell 10' of FIG. 4 can be manufactured by the same production method described with reference to FIG. 2, except that the emitter layer 15 is formed on the back surface (the second main surface 19) side. In the solar cell 10' of FIG. 4, however, the front surface electrodes 14 are preferably formed of Al, and the back surface electrode 16 is preferably formed of Ag.

The solar cell 10' of FIG. 4 also can possess high conversion efficiency while suppressing the photo-degradation even though having a silicon thermal oxide film as a passivation film of the substrate surface as with the solar cell 10 of FIG. 1.

### EXAMPLES

Hereinafter, the present invention will be specifically described with reference to Examples, but the present invention is not limited thereto.

### (Example)

The solar cell 10 shown in FIG. 1 was produced by manufacturing processes shown in FIG. 2 and FIG. 3.

First, as the silicon substrate 11, plural of p-type as-cut silicon substrates with the plane orientation of {100} doped with gallium and boron having a thickness of 200 µm and a specific resistance of 1 Ω·cm were prepared (see FIG. 2(a)). The silicon substrates were cut out from plural silicon single crystal ingots, which were produced by a CZ method with the doping amount of boron being changed. The specific resistances of the silicon substrates were measured previously, and the measured substrates were selected so as to have a specific resistance of 1 Ω·cm in any doping amount of boron. The doping amount of gallium was adjusted so as to have a specific resistance of 1 Ω·cm on the basis of the doping amount of boron.

Then, texture processing was performed as follows. The damaged layer of the silicon substrate 11 was removed with a hot concentrated potassium hydroxide solution. Subsequently, the silicon substrate 11 was immersed to an aqueous solution of potassium hydroxide and 2-propanol to form a texture.

Next, the silicon substrate 11 was subjected to heat treatment at 870°C in a phosphorus oxychloride atmosphere to perform phosphorous diffusion. In this case, plural of the silicon substrate 11 were heat treated with the back surfaces thereof being superposed with each other. The phosphorous glass layer after the diffusion wad removed with hydrofluoric acid, followed by cleaning and drying. In this way, the emitter layer 15, which is an n-type diffusion layer, was formed on the second main surface 19 side of the silicon substrate 11 (see FIG. 2(b)).

Then, thermal oxidation was performed as follows. The silicon substrate 11 was subjected to a heat treatment at 900°C for 40 minutes in an oxygen atmosphere after cleaning in a hydrochloric acid/hydrogen peroxide mixed solution to form the silicon thermal oxide film 12 of 15 nm on the back surface (the first main surface 18) of the silicon substrate 11 (see FIG. 2(c)). In this time, the silicon thermal oxide film 12' was also formed on the front surface (the second main surface 19) of the silicon substrate 11.

Subsequently, formation of silicon nitride films was performed as follows. The silicon nitride films 13 and 13' each having a film thickness of 80 nm were formed on the silicon thermal oxide films 12 and 12' on the back surface side (the first main surface 18 side) of the silicon substrate 11 and the front surface side (the second main surface 19 side) of the silicon substrate 11 (see FIG. 3(a)).

Next, formation of silver film for forming the front surface electrodes 14 was performed by screen printing of Ag paste followed by drying.

Then, the front surface electrodes 14 were formed by baking at 780°C in an air atmosphere. In this time, the front surface electrodes 14 were pierced through the silicon nitride film 13' and the silicon thermal oxide film 12' to be connected to the emitter layer 15 (see FIG. 3(b)).

Subsequently, the silicon nitride film 13 and the silicon thermal oxide film 12 on the back surface side (the first main surface 18 side) of the silicon substrate 11 were removed in line shapes having spaces of 1 mm with each other by using laser.

Next, the back surface electrode 16 was formed by vapor deposition of Al onto the entire surface of the back surface (the first main surface 18) of the silicon substrate 11. Thus, the solar cell 10 shown in FIG. 1 was produced.

Regarding the solar cell 10 produced as described above, the electronic properties were measured in irradiating pseudo-sunlight of a spectrum AM 1.5 global with an irradiation of 100 mW/cm² at 25°C. The electronic properties were measured regarding the initial property (i.e., the initial conversion efficiency) and regarding the property after degradation (i.e., the conversion efficiency after degradation measured after 2 hours of continuous photo-radiation by the same condition as on the initial conversion efficiency). Herein, the conversion efficiency is (output from the solar cell/incident optical energy into the solar cell)×100. The measured results are shown in FIG. 5. In FIG. 5, the degradation degree was defined as (conversion efficiency after degradation/initial conversion efficiency)×100.

As can be seen from FIG. 5, when the boron concentration in a silicon substrate exceeded 5×10¹⁴ atoms/cm³, photo-degradation began to occur although the initial conversion efficiency was improved due to an increase of the p-type dopant concentration around the surface of the substrate and an effect of increased passivation of the oxide film. When the boron concentration in the silicon substrate was within the range of 5×10¹⁴ to 1×10¹⁶ atoms/cm³, however, an effect of improving the initial efficiency was larger than that of the photo-degradation. Accordingly, the conversion efficiency was higher than that when the boron amount is small (without degradation) even after degradation, which reveals that the boron concentration within the range described above is particularly preferable.

It is to be noted that the present invention is not limited to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A solar cell comprising a gallium-doped silicon substrate having a p-n junction formed therein,
wherein the silicon substrate is provided with a silicon thermal oxide film at least on a first main surface of main surfaces of the silicon substrate, the first main surface being a main surface having a p-type region, and
the silicon substrate is further doped with boron,
wherein the silicon substrate has a boron concentration of 5×10¹⁴ atoms/cm³ or more and 1×10¹⁶ atoms/cm³ or less.

2. The solar cell according to claim 1, wherein, in the silicon substrate, at least the first main surface is a p-type entirely.

3. A method for manufacturing a solar cell, comprising the steps of:
preparing a silicon substrate doped with gallium and boron;
forming a p-n junction in the silicon substrate; and
forming a silicon thermal oxide film at least on a first main surface of main surfaces of the silicon substrate, the first main surface being a main surface having a p-type region,
wherein the silicon substrate to be prepared has a boron concentration of 5×10¹⁴ atoms/cm³ or more and 1×10¹⁶ atoms/cm³ or less.

## Patentansprüche

1. Solarzelle, umfassend ein Gallium-dotiertes Siliziumsubstrat mit einer darin gebildeten p-n-Verbindung,
wobei das Siliziumsubstrat mit einem thermischen Siliziumoxidfilm ausgestattet ist, mindestens auf einer ersten Hauptfläche von Hauptflächen des Siliziumsubstrats, wobei die erste Hauptfläche eine Hauptfläche ist, die einen p-Typ-Bereich hat, und
das Siliziumsubstrat ist weiterhin mit Bor dotiert,
wobei das Siliziumsubstrat eine Bor-Konzentration von 5x10¹⁴ Atome/cm³ oder darüber und 1x10¹⁶ Atome/cm³ oder darunter hat.

2. Solarzelle nach Anspruch 1, wobei in dem Siliziumsubstrat mindestens die erste Hauptfläche vollständig ein p-Typ ist.

3. Verfahren zur Herstellung einer Solarzelle, umfassend die Schritte von:
Herstellung eines Siliziumsubstrats, dotiert mit Gallium und Bor;
Bildung einer p-n-Verbindung in dem Siliziumsubstrat; und
Bildung eines thermischen Siliziumoxidfilms, mindestens auf einer ersten Hauptfläche von Hauptflächen des Siliziumsubstrats, wobei die erste Hauptfläche eine Hauptfläche ist mit einem p-Typ-Bereich,
wobei das herzustellende Siliziumsubstrat eine Bor-Konzentration von 5x10¹⁴ Atome/cm³ oder darüber und 1x10¹⁶ Atome/cm³ oder darunter hat.

## Revendications

1. Cellule solaire comprenant un substrat de silicium dopé au gallium dans lequel est formée une jonction p-n,
dans laquelle le substrat de silicium est pourvu d'un film d'oxyde thermique de silicium au moins sur une première surface principale des surfaces principales du substrat de silicium, la première surface principale étant une surface principale ayant une région de type p, et
le substrat de silicium est en outre dopé avec du bore,
dans laquelle le substrat de silicium a une concentration en bore de 5x10¹⁴ atomes/cm³ ou plus et de 1x10¹⁶ atomes/cm³ ou moins.

2. Cellule solaire selon la revendication 1, dans laquelle, dans le substrat de silicium, au moins la première surface principale est entièrement de type p.

3. Procédé de fabrication d'une cellule solaire, comprenant les étapes de :
préparation d'un substrat de silicium dopé au gallium et au bore ;
formation d'une jonction p-n dans le substrat de silicium ; et
formation d'un film d'oxyde thermique de silicium au moins sur une première surface principale des surfaces principales du substrat de silicium, la première surface principale étant une surface principale ayant une région de type p,
dans lequel le substrat de silicium à préparer présente une concentration en bore de 5x10¹⁴ atomes/cm³ ou plus et de 1x10¹⁶ atomes/cm³ ou moins.
